(19) Europäisches Patentamt
European Patent Office
Office européen des brevets

(11) **EP 2 157 618 B1**

(12) **EUROPEAN PATENT SPECIFICATION**

(45) Date of publication and mention
of the grant of the patent:
**24.07.2013 Bulletin 2013/30**

(51) Int Cl.:
*H01B 1/22* (2006.01)          *C03C 8/02* (2006.01)
*C03C 8/04* (2006.01)          *C03C 8/10* (2006.01)
*C03C 8/18* (2006.01)          *H01L 31/0224* (2006.01)
*H01L 31/068* (2012.01)        *C03C 14/00* (2006.01)

(21) Application number: **08739954.9**

(22) Date of filing: **07.04.2008**

(86) International application number:
**PCT/JP2008/056851**

(87) International publication number:
**WO 2008/152854 (18.12.2008 Gazette 2008/51)**

(54) **PASTE COMPOSITION AND SOLAR CELL ELEMENT**

PASTENZUSAMMENSETZUNG UND SOLARZELLENELEMENT

COMPOSITION DE PÂTE ET ÉLÉMENT DE PILE SOLAIRE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **08.06.2007 JP 2007152469**

(43) Date of publication of application:
**24.02.2010 Bulletin 2010/08**

(73) Proprietor: **TOYO ALUMINIUM KABUSHIKI KAISHA**
**Chuo-ku**
**Osaka-shi**
**Osaka 541-0056 (JP)**

(72) Inventors:
• **LAI, Gaochao**
**Osaka-shi**
**Osaka 541-0056 (JP)**
• **OCHI, Yutaka**
**Osaka-shi**
**Osaka 541-0056 (JP)**
• **MIYAZAWA, Yoshiteru**
**Osaka-shi**
**Osaka 541-0056 (JP)**
• **WATSUJI, Takashi**
**Osaka-shi**
**Osaka 541-0056 (JP)**
• **KATOH, Haruzo**
**Osaka-shi**
**Osaka 541-0056 (JP)**

(74) Representative: **Grünecker, Kinkeldey, Stockmair & Schwanhäusser**
**Leopoldstrasse 4**
**80802 München (DE)**

(56) References cited:
**JP-A- 06 024 834     JP-A- 2006 278 071**

• **DATABASE WPI Week 200744 Thomson Scientific, London, GB; AN 2007-446370 XP002655521, -& CN 1 877 864 A (TAN F) 13 December 2006 (2006-12-13)**

**Description**

TECHNICAL FIELD

The present invention relates generally to paste compositions and solar cell elements and, more particularly, to a paste composition used when an electrode is formed on a back surface of a silicon semiconductor substrate constituting a crystalline silicon solar cell, and to a solar cell element in which a back surface electrode is formed by using the paste composition.

BACKGROUND ART

As an electronic component having an electrode formed on a silicon semiconductor substrate, solar cell elements disclosed in Japanese Patent Application Laid-Open Publication No. 2000-90734 (Patent Document 1) and Japanese Patent Application Laid-Open Publication No. 2004-134775 (Patent Document 2) have been known.

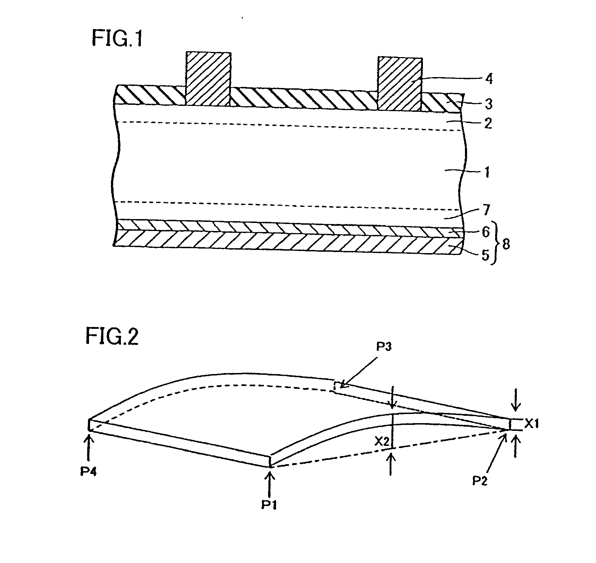

Fig. 1 is a schematic view showing a general sectional structure of a solar cell element.

As shown in Fig. 1, the solar cell element is structured by using a p-type silicon semiconductor substrate 1 whose thickness is 200 to 300 $\mu$m. On a side of a light receiving surface of the p-type silicon semiconductor substrate 1, an n-type impurity layer 2 whose thickness is 0.3 to 0.6 pm, and an antireflection film 3 and grid electrodes 4, which are on the n-type impurity layer 2, are formed.

On a side of a back surface of the p-type silicon semiconductor substrate 1, an aluminum electrode layer 5 is formed. The formation of the aluminum electrode layer 5 is conducted through applying a paste composition containing aluminum powder, a glass frit, and an organic vehicle by employing screen printing or the like; drying; and thereafter, firing the resultant for a short period of time at a temperature greater than or equal to 660°C (melting point of aluminum). During the firing, the aluminum is diffused into the p-type silicon semiconductor substrate 1, whereby an Al-Si alloy layer 6 is formed between the aluminum electrode layer 5 and the p-type silicon semiconductor substrate 1 and concurrently, a p+ layer 7 is formed as an impurity layer resulting from diffusion of aluminum atoms. The presence of the p+ layer 7 prevents recombination of electrons, and therefore, a BSF (Back Surface Field) effect which enhances an efficiency of collecting generated carriers can be obtained.

For example, as disclosed in Japanese Patent Application Laid-Open Publication No. 5-129640 (Patent Document 3), a solar cell element in which a back surface electrode 8 including an aluminum electrode layer 5 and an Al-Si alloy layer 6 is removed by using acid or the like and a collecting electrode layer is newly formed by using a silver paste or the like has been put into practical use. However, since disposal of the acid used for removing the back surface electrode 8 is required, for example, a problem that the disposal makes a process complicated arises. In recent years, in order to avoid such a problem, many solar cell elements have been structured with the back surface electrode 8 left as it is and utilized as a collecting electrode.

In the meantime, although in a solar cell element in which a back surface electrode is formed through applying a conventional paste composition containing aluminum powder onto a back surface of a p-type silicon semiconductor substrate and through firing the resultant, a certain efficiency of collecting generated carriers has been obtained, it has been required to further enhance the desired BSF effect in order to increase a conversion efficiency.

In order to enhance the conversion efficiency, it has been proposed in Japanese Patent Application Laid-Open Publication No. 2001-202822 (Patent Document 4) that a particle size of the aluminum powder in the paste composition used for forming a back surface electrode and a thickness of an oxide film are limited. However, even by using such a paste composition, it is impossible to sufficiently enhance the BSF effect so as to allow a higher conversion efficiency to be achieved.

There is a method to enhance the BSF effect, in which diffusion of aluminum is promoted by increasing an application amount of the paste composition. On the other hand, in order to solve a problem of a shortage of a silicon material and to reduce costs in manufacturing solar cells, rendering a the p-type silicon semiconductor substrate thinner has been examined these days. However, when the p-type silicon semiconductor substrate is rendered thinner, after firing the paste composition, a side of a back surface having an electrode layer formed thereon is deformed in a concave manner due to a difference between thermal expansion coefficients of silicon and the aluminum, thereby deforming and bowing the p-type silicon semiconductor substrate. Consequently, fractures or the like are caused in a process of manufacturing the solar cells, thereby resulting in a problem that manufacturing yields of the solar cells are reduced.

There is a method to solve this problem, in which an application amount of the paste composition is decreased and a back surface electrode layer is rendered thinner. However, when the application amount of the paste composition is decreased, an amount of the aluminum diffused from the back surface of the p-type silicon semiconductor substrate to an inside thereof is easily made insufficient and as a result, a desired BSF effect cannot be achieved, thereby incurring a problem that properties of the solar cell are reduced.

A composition of an electrically conductive paste which allows desired properties of the solar cell to be ensured and the back surface electrode layer to be rendered thinner is disclosed in, for example, Japanese Patent Application Laid-Open Publication No. 2000-90734 (Patent Document 1). In addition to aluminum powder, a glass frit, and an organic vehicle, this electrically conductive paste further contains an organic compound containing aluminum. However, although the above-mentioned conventional art can reduce an amount of a bow of the p-type silicon semiconductor substrate by rendering the back surface electrode layer thinner, the above-mentioned conventional art cannot sufficiently enhance the BSF effect so as to allow the higher conversion efficiency to be achieved.

Patent Document 1: Japanese Patent Application Laid-Open Publication No. 2000-90734
Patent Document 2: Japanese Patent Application Laid-Open Publication No. 2004-134775
Patent Document 3: Japanese Patent Application Laid-Open Publication No. 5-129640
Patent Document 4: Japanese Patent Application Laid-Open Publication No. 2001-202822
CN 1 877 864 A discloses an aluminum conductive slurry component for a silicon solar battery and its method of production.

## DISCLOSURE OF THE INVENTION

Problems to be solved by the invention

Hence, objects of the present invention are to solve the above-mentioned problems and to provide a paste composition which is capable of sufficiently achieving at least a BSF effect equivalent to or greater than a conventionally achieved BSF effect even when the paste composition is used in either case where a thick back surface electrode layer is formed on a comparatively thick silicon semiconductor substrate or where a thin back surface electrode layer is formed on a comparatively thin silicon semiconductor substrate, and which is capable of not only achieving the BSF effect equivalent to or greater than the conventionally achieved BSF effect but also suppressing a deformation of the silicon semiconductor substrate after being fired when the paste composition is used in the case where the thin back surface electrode layer is formed on the comparatively thin silicon semiconductor substrate; and a solar cell element comprising an electrode formed by using the above-mentioned composition.

Means for solving the problems

In order to solve the problems of the conventional art, the present inventors have repeated eager researches. As a result, the present inventors found that the above-mentioned objects can be achieved by using a paste composition in which a content of specific metal elements, among inevitable impurity elements, is limited. Based on the findings, the paste composition according to the present invention has the following features.

A paste composition according to the present invention is used for forming an electrode on a back surface of a silicon semiconductor substrate constituting a crystalline silicon solar cell and comprises the features of claim 1. Preferable embodiments are defined in dependent claims 2-10.

A solar cell element according to the present invention comprises an electrode formed by applying a paste composition according to claim 1 onto a back surface of a silicon semiconductor substrate and thereafter, firing a resultant.

## EFFECT OF THE INVENTION

As described above, according to the present invention, even when a paste composition whose total content of iron and titanium contained therein as inevitable impurity elements is limited to be less than or equal to 0.07% by mass is used in either case where a thick back surface electrode layer is formed on a comparatively thick silicon semiconductor substrate or where a Preferable embodiments are defined in dependent claims 2-10. thin back surface electrode layer is formed on a comparatively thin silicon semiconductor substrate, at least a BSF effect equivalent to or greater than a conventionally achieved BSF effect can be sufficiently achieved; and when the above-mentioned paste composition is used in the case where the thin back surface electrode layer is formed on the comparatively thin silicon semiconductor substrate, not only the BSF effect equivalent to or greater than the conventionally achieved BSF effect can be achieved but also a deformation of the silicon semiconductor substrate after being fired can be suppressed.

## BRIEF DESCRIPTION OF THE DRAWINGS

Fig. 1 is a schematic view showing a general sectional structure of a solar cell element to which the present invention as one embodiment is applied.

Fig. 2 is a schematic view showing a method for measuring bow amounts of p-type silicon semiconductor substrates of examples and comparison examples, each of which has an aluminum electrode layer formed therein as a back surface electrode layer and has been fired.

EXPLANATION OF REFERENCE NUMERALS

1: p-type silicon semiconductor substrate, 2: n-type impurity layer, 3: antireflection film, 4: grid electrode, 5: aluminum electrode layer, 6: Al-Si alloy layer, 7: p$^+$ layer, 8: back surface electrode.

BEST MODE FOR CARRYING OUT THE INVENTION

The present inventors focused attention on a relationship between properties of a solar cell element and contents of transition metal elements, particularly iron (Fe) and titanium (Ti) elements, contained in a paste composition as inevitable impurities due to aluminum powder and discovered that the properties of the solar cell element can be enhanced by reducing the contents of the Fe and Ti elements in the paste composition. Such findings by the inventors are as described below.

When a back surface electrode layer is formed through applying a conventional paste composition onto a back surface of a silicon semiconductor substrate and through firing the resultant, aluminum as an electrically conductive component contained in the paste composition is diffused inside the silicon semiconductor substrate and concurrently, an Fe element and a Ti element as inevitable impurities contained in the paste composition are also diffused inside the silicon semiconductor substrate. Because of this, the Fe element and the Ti element hamper the diffusion of the aluminum.

In contrast to this, in the present invention, the aluminum is easily diffused inside the silicon semiconductor substrate by reducing a total content of the Fe and Ti elements in the paste composition so as to be less than or equal to a predetermined value.

On the other hand, when a back surface electrode layer is formed by applying the conventional paste composition onto the back surface of the silicon semiconductor substrate and through firing the resultant, the Fe element and the Ti element, diffused inside the silicon semiconductor substrate, enter an inside or outside of a silicon lattice, thereby forming a lattice defect and reducing a BSF effect.

In contrast to this, in the present invention, the total content of the Fe and Ti elements in the paste composition is reduced so as to be less than or equal to the predetermined value, thereby allowing an amount of the Fe and Ti elements diffused inside the silicon semiconductor substrate to be reduced and enabling the BSF effect to be enhanced. As a result, the properties of the solar cell element can be improved.

Based on the above-described findings by the inventors, in the paste composition of the present invention, the total content of the iron and the titanium contained in the paste composition as the inevitable impurity elements is less than or equal to 0.07% by mass and preferably, a content of the iron is less than or equal to 0.07% by mass.

It is preferable that the paste composition of the present invention further contains an organic vehicle. Components of the contained organic vehicle are not particularly limited, and a resin such as an ethyl cellulose based resin and an alkyd based resin and a solvent such as a glycol ether based solvent and a terpineol based solvent can be used. It is preferable that a content of the organic vehicle is greater than or equal to 18% by mass and less than or equal to 38% by mass. If the content of the organic vehicle is less than 18% by mass or exceeds 38% by mass, printing performance of the paste is degraded.

It is preferable that a content of aluminum powder contained in the paste composition of the present invention is greater than or equal to 58% by mass and less than or equal to 78% by mass. If the content of the aluminum powder is less than 58% by mass, a resistance of the aluminum electrode layer after being fired is increased, whereby a reduction in an energy conversion efficiency of a solar cell is likely to be incurred. If the content of the aluminum powder exceeds 78% by mass, application performance of the paste in screen printing or the like are reduced. In addition, as the aluminum powder, in consideration of ensuring of reactivity with the silicon semiconductor substrate, application performance, and uniformity of coating films, it is preferable to use aluminum powder having an average particle size of 1 through 20 $\mu$m and more preferable to use aluminum powder having an average particle size of 2 through 8 $\mu$m. Although a shape of each particle of the aluminum powder is not particularly limited, it is better to use powder whose each particle is of a spherical shape or a near-spherical shape. In order to satisfy conditions of the composition of the present invention, it is preferable to use aluminum powder whose content of the Fe and the Ti is small. It is only required that the aluminum powder has the small content of the Fe and the Ti and the total content of the Fe and the Ti in the paste composition of the present invention is less than or equal to the predetermined amount. Although other than these, the aluminum powder used in the present invention is not particularly limited, it is preferable to use, for example, high-purity aluminum powder containing the Fe and Ti whose total content is less than or equal to 0.09% by mass. If the total content of the Fe and the Ti in the paste composition is less than or equal to 0.07% by mass, aluminum powder whose total content of the Fe and the Ti is greater than or equal to 0.09% by mass and high-purity aluminum powder whose total content of the Fe and the Ti is less than or equal to 0.09% by mass is used in combination.

Furthermore, the paste composition of the present invention may contain a glass frit. It is preferable that a content of the glass frit is less than or equal to 8% by mass. The glass frit also has an effect of enhancing adhesion performance of the aluminum electrode layer after being fired. However, if the content of the glass frit exceeds 8% by mass, segregation in glass occurs, whereby a resistance of the aluminum electrode layer as the back surface electrode layer is likely to be increased. Although it is only required for an average particle size of the glass frit not to adversely affect the effect of the present invention and the average particle size of the glass frit is not particularly limited, a glass frit whose average particle size is approximately 1 through 4 $\mu$m can be favorably used. In order to satisfy the conditions of the composition of the present invention, it is only required to use a glass frit having a small amount of the Fe and the Ti.

The glass frit contained in the paste composition of the present invention and in particular, composition and contents of components thereof are not limited, and ordinarily, a glass frit whose softening point is less than or equal to a firing temperature is used. Ordinarily, as the glass frit, a $B_{2}P_{3}$-$SiO_{2}$-$Bi_{2}O_{3}$ based glass frit, a $B_{2}O_{3}$-$SiO_{2}$-$ZnO$ based glass frit, a $B_{2}O_{3}$-$SiO_{2}$-$PbO$ based glass frit, or the like in addition to a $SiO_{2}$-$Bi_{2}O_{3}$-$PbO$ based glass frit can be used.

EXAMPLES

Hereinafter, examples of the present invention will be described.

Kinds of aluminum powder A and B shown in Table 1 and glass frits a, b, and c shown in Table 2 were prepared, and these were used as raw powder materials of examples 1 through 9 and comparison examples 1 through 6. Average particle sizes of the respective kinds of the aluminum powder and the glass frits were values measured by employing laser diffractometry.

Next, various paste compositions (total content 100% by mass) were prepared as shown in Table 3 such that each paste composition contained a total content of 74% by mass or 76% by mass, in each predetermined proportion, of the aluminum powder A and the aluminum powder B shown in Table 1; said each paste composition contained 2% by mass of each of the glass frits a, b, and c shown in Table 2 or no glass frit was added thereto; and as a remainder, said each paste composition contained an organic vehicle wherein ethyl cellulose whose content with respect to said each paste composition was 2% by mass was dissolved in a glycol ether based organic solvent.

Specifically, by adding the respective kinds of the aluminum powder and the glass frit to the organic vehicle wherein the ethyl cellulose was dissolved in the glycol ether based organic solvent and blending them with a well-known mixer, the paste compositions (examples 1 through 9) whose total contents of Fe and Ti in the paste compositions were in a range specified in the present invention were prepared. In addition, by employing the same method as described above, as shown in Table 3, the paste compositions (comparison examples 1 through 6) whose total contents of the Fe and the Ti were out of the range specified in the present invention were prepared.

The total contents of the Fe and the Ti in the paste compositions shown in Table 3 were analyzed by employing the following method. Five grams of each of the paste compositions were taken and put into a sample tube, 30 grams of chloroform were added therein and ultrasonic cleaning was performed. These processed resultants were subjected to centrifugal separation, thereafter, supernatant liquor was removed, and solid matters were dried with a drier for one hour at a temperature of 80°C. The obtained solid matters were used as test samples and subjected to acid dissolution and thereafter, a quantitative analysis was conducted by employing inductively coupled plasma-atomic emission spectrometry (ICP-AES, manufactured by Thermo Electron Corporation, model: i-CAP6500).

Next, as shown in Fig. 1, a silicon wafer as a p-type silicon semiconductor substrate 1 having a thickness of a formed pn junction of 180 $\mu$m or 250 $\mu$m and dimensions of 125 mm $\times$ 125 mm was prepared, a grid electrode 4 made of Ag was formed on a light receiving surface of the silicon wafer, and the resultant was used to evaluate the paste composition of the present invention.

By employing a screen printing method, a paste composition of each of the examples 1 through 9 and each of the comparison examples 1 through 6 was applied on a back surface of the above-mentioned silicon wafer with a printing pressure of 0.2 kg/cm$^2$ and an application amount after drying was adjusted to be 0.7 through 0.8 g/wafer (325-mesh screen printing plate used) or 0.95 through 1.05 g/wafer (200-mesh screen printing plate used), thereby preparing application layers of the respective paste compositions.

The application layers formed as described above were dried at a temperature of 100°C and thereafter, fired in an infrared firing furnace at a maximum temperature of 830°C, and thereby, back surface electrode layers were formed, thus preparing test samples of the examples 1 through 9 and the comparison examples 1 through 6.

Here, in the test samples of the examples 7 and 8, the paste compositions of the examples 4 and 6 were used and the application amounts of the paste compositions used therein and the thicknesses of the silicon wafers were different from those of the test samples of the examples 4 and 6. In the test samples of the comparison examples 5 and 6, the paste composition of the comparison example 2 was used and the application amounts of the paste composition used therein and the thicknesses of the silicon wafers were different from those of the test sample of the example 2.

A bow (deformation) amount of each of the test samples prepared as described above was measured by a laser displacement meter (a display unit: LK-GD500 and a sensor: LK-G85, manufactured by KEYENCE Corporation). A method of measuring the bow is as follows.

First, each of the silicon wafers was placed on a flat surface such that the back surface (concave surface) of each of the test samples, that is, a surface of each of the silicon wafers, to which each of the paste compositions was applied, faces downward. As shown in Fig. 2, a side spanning between P1 and P4 of each of the silicon wafer, placed on the flat surface, and a side spanning between P2 and P3 thereof are in contact with the flat surface whereas a side spanning between P1 and P2 thereof and a side spanning between P3 and P4 thereof are bulging upward above the flat surface due to the deformation caused by the bow.

Based on this, the measurement was conducted while the laser displacement meter was being moved on the side spanning between P1 and P2. As values measured by using the laser displacement meter, a minimum displacement value (X1) indicates a thickness of each of the silicon wafer (including a thickness of the back surface electrode layer) since a position of P2 (or P1) is in contact with the flat surface, and a maximum displacement value (X2) indicates a total value of the thickness of each of the silicon wafer and the bow (deformation) amount. Based on this, a bow amount of each of the test samples was calculated from the maximum displacement value (X2) and the minimum displacement value (X1) of the values measured with the laser displacement meter by using the following equation.

$$\text{Bow (mm) amount} = \text{Maximum displacement value (X2)} - \text{Minimum displacement value (X1)}$$

Next, in the same way as described above, the measurement was conducted while the laser displacement meter was being moved on the side spanning between P3 and P4, opposite to the side spanning between P1 and P2 and thereby, a bow amount of each of the test samples was calculated by using the above-mentioned equation.

As described above, an average value of a value of the bow amount, obtained by the measurement on the side spanning between P1 and P2, and a value of the bow amount, obtained by the measurement on the side spanning between P3 and P4, was calculated as a value of the bow amount of each of the test samples.

In addition, conversion efficiencies (Eff) of the solar cell elements of the test samples of the examples 1 through 9 and the comparison examples 1 through 6, prepared as described above, were respectively measured by using a solar simulator (was-155S-10, manufactured by WACOM ELECTRIC CO., LTD.) under conditions of a temperature of 25 °C and AM1.5G spectrum.

A result of the above-mentioned measurement is shown in Table 3.

In a column of the "application amount" in Table 3, "Small" shows that an application amount after the drying is 0.7 through 0.8 g/wafer and "Large" shows that an application amount after the drying is 0.95 through 1.05 g/wafer. In a column of the "Bow" therein, "○" shows that a value of the bow amount is less than or equal to 1.0 mm and " × " shows that a value of the bow amount is greater than or equal to 1.0 mm.

[Table 1]

| Aluminum Powder | Average Particle Size [μm] | Total Content of Fe and Ti [% by mass] |
|---|---|---|
| A | 5 | 0.005 |
| B | 5 | 0.2 |

[Table 2]

| Glass Frit | Components | Average Particle Size [μm] |
|---|---|---|
| a | $B_2O_3$-$SiO_2$-PbO Based | 3 |
| b | $B_2O_3$-$SiO_2$-ZnO Based | 2 |
| c | $B_2O_3$-$SiO_2$-$Bi_2O_3$ Based | 2 |

[Table 3]

| Example | Aluminum Powder | | Glass Frit | Total Content of Fe and Ti in Paste Composition [% by mass] | Content of Fe in Paste Composition [% by mass] | Content of Ti in Paste Composition [% by mass] | Application Amount | Wafer Thickness [μm] | Bow | Conversion Efficiency [%] |
|---|---|---|---|---|---|---|---|---|---|---|
| | A [% by mass] | B [% by mass] | | | | | | | | |
| Example 1 | 72 | 4 | Not Added | 0.011 | 0.01 | 0.001 | Small | 180 | ○ | 15.4 |
| Example 2 | 70 | 4 | a | 0.011 | 0.01 | 0.001 | Small | 180 | ○ | 15.6 |
| Example 3 | 70 | 4 | b | 0.011 | 0.01 | 0.001 | Small | 180 | ○ | 15.5 |
| Example 4 | 70 | 4 | c | 0.011 | 0.01 | 0.001 | Small | 180 | ○ | 15.5 |
| Example 5 | 48 | 28 | Not Added | 0.063 | 0.06 | 0.003 | Small | 180 | ○ | 15.1 |
| Example 6 | 46 | 28 | c | 0.063 | 0.06 | 0.003 | Small | 180 | ○ | 15.2 |
| Example 7 | 70 | 4 | c | 0.011 | 0.01 | 0.001 | Large | 250 | ○ | 15.9 |
| Example 8 | 46 | 28 | c | 0.063 | 0.06 | 0.003 | Large | 250 | ○ | 15.6 |
| Example 9 | 60 | 14 | c | 0.032 | 0.03 | 0.002 | Small | 180 | ○ | 15.4 |
| Comparison Example 1 | 38 | 38 | Not Added | 0.084 | 0.08 | 0.004 | Small | 180 | ○ | 14.7 |
| Comparison Example 2 | 36 | 38 | c | 0.084 | 0.08 | 0.004 | Small | 180 | ○ | 14.9 |
| Comparison Example 3 | 24 | 50 | c | 0.095 | 0.09 | 0.005 | Small | 180 | ○ | 14.3 |
| Comparison Example 4 | 0 | 74 | c | 0.158 | 0.15 | 0.008 | Small | 180 | ○ | 13.9 |
| Comparison Example 5 | 36 | 38 | c | 0.084 | 0.08 | 0.004 | Large | 250 | ○ | 15.2 |
| Comparison Example 6 | 36 | 38 | c | 0.084 | 0.08 | 0.004 | Large | 180 | × | 15.0 |

EP 2 157 618 B1

It is seen from the result shown in Table 3 that except for the comparison example 6 in which the value of the bow was greater than or equal to 1.0 mm (rejectable), the value of each of the bows of all the other test samples was less than or equal to 1.0 mm (acceptable level).

In addition, it is understood from the result shown in Table 3 that by using each of the paste compositions (examples 1 through 9) of the present invention, in a case where the comparatively thick silicon semiconductor substrate (having the thickness of 250 pm) which had conventionally been used was used, it was made possible to further enhance the conversion efficiency of the solar cell element, and in a case where the comparatively thin silicon semiconductor substrate (having the thickness of 180 $\mu$m) was used, it was made possible to not only suppress the deformation of the substrate but also achieve the conversion efficiency of the solar cell element, which was equivalent to or greater than that of the conventional solar cell element, by decreasing the application amount of the paste composition.

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

INDUSTRIAL APPLICABILITY

According to the present invention, even when a paste composition whose total content of iron and titanium contained therein as inevitable impurity elements is limited to be less than or equal to 0.07% by mass is used in either case where a thick back surface electrode layer is formed on a comparatively thick silicon semiconductor substrate or where a thin back surface electrode layer is formed on a comparatively thin silicon semiconductor substrate, at least a BSF effect equivalent to or greater than a conventionally achieved BSF effect can be sufficiently achieved; and when the above-mentioned paste composition is used in the case where the thin back surface electrode layer is formed on the comparatively thin silicon semiconductor substrate, not only the BSF effect equivalent to or greater than the conventionally achieved BSF effect can be achieved but also a deformation of the silicon semiconductor substrate after being fired can be suppressed.

**Claims**

1. A paste composition used for forming an electrode (8) on a back surface of a silicon semiconductor substrate (1) constituting a crystalline silicon solar cell, the paste composition comprising aluminum powder as electrically conductive powder,
   **characterized in that**
   a total content of iron and titanium contained in the paste composition as inevitable impurity elements is less than or equal to 0.07% by mass, and
   wherein aluminum powder whose total content of iron and titanium is greater than or equal to 0.09 % by mass and high-purity aluminum powder whose total content of iron and titanium is less than or equal to 0.09 % by mass are used in combination.

2. The paste composition according to claim 1, wherein a content of the iron is less than or equal to 0.07% by mass.

3. The paste composition according to claim 1, further comprising an organic vehicle.

4. The paste composition according to claim 3, wherein a content of the organic vehicle is greater than or equal to 18% by mass and less than or equal to 38% by mass.

5. The paste composition according to any one of claims 1 to 4, wherein a content of aluminum powder is greater than or equal to 58% by mass and less than or equal to 78% by mass.

6. The paste composition according to any one of claims 5, wherein an average particle size of aluminum powder is in the range of 1 through 20 $\mu$m.

7. The paste composition according to any one of claims 1 to 6, wherein aluminum powder whose total content of iron and titanium is 0.005 % by mass and high-purity aluminum powder whose total content of iron and titanium is 0.2 % by mass are used in combination.

8. The paste composition according to claim 1, further comprising a glass frit.

9. The paste composition according to claim 8, wherein a content of the glass frit is less than or equal to 8% by mass.

10. The paste composition according to claim 8 or 9, wherein an average particle size of glass frit is in the range of 1 through 4 $\mu$m.

11. A solar cell element comprising an electrode (8) formed by applying a paste composition according to claim 1 onto a back surface of a silicon semiconductor substrate (1) and thereafter, firing a resultant.

**Patentansprüche**

1. Pastenzusammensetzung, die zum Ausbilden einer Elektrode (8) an einer Rückseite eines Silizium-Halbleitersubstrats (1) eingesetzt wird, das eine Solarzelle aus kristallinem Silizium bildet, wobei die Pastenzusammensetzung Aluminiumpulver als elektrisch leitendes Pulver umfasst,
**dadurch gekennzeichnet, dass**
ein Gesamtgehalt an Eisen und Titan, die in der Pastenzusammensetzung als unvermeidbare Verunreinigungselemente enthalten sind, 0,07 Gew.-% oder weniger beträgt,
wobei Aluminiumpulver, dessen Gesamtgehalt an Eisen und Titan 0,09 Gew.-% oder mehr beträgt, und hochreines Aluminiumpulver, dessen Gesamtgehalt an Eisen und Titan 0,09 Gew.-% oder weniger beträgt, in Kombination verwendet werden.

2. Pastenzusammensetzung nach Anspruch 1, wobei ein Gehalt an Eisen 0,07 Gew.-% oder weniger beträgt.

3. Pastenzusammensetzung nach Anspruch 1, die des Weiteren eine organische Trägersubstanz umfasst.

4. Pastenzusammensetzung nach Anspruch 3, wobei ein Gehalt an der organischen Trägersubstanz 18 Gew.-% oder mehr und 38 Gew.-% oder weniger beträgt.

5. Pastenzusammensetzung nach einem der Ansprüche 1 bis 4, wobei ein Gehalt an Aluminiumpulver 58 Gew.-% oder mehr und 78 Gew.-% oder weniger beträgt.

6. Pastenzusammensetzung nach einem der Ansprüche 1 bis 5, wobei eine durchschnittliche Teilchengröße des Aluminiumpulvers im Bereich von 1 bis 20 $\mu$m liegt.

7. Pastenzusammensetzung nach einem der Ansprüche 1 bis 6, wobei Aluminiumpulver, dessen Gesamtgehalt an Eisen und Titan 0,005 Gew.-% beträgt, sowie hochreines Aluminiumpulver, dessen Gesamtgehalt an Eisen und Titan 0,2 Gew.-% beträgt, in Kombination verwendet werden.

8. Pastenzusammensetzung nach Anspruch 1, das des Weiteren eine Glasfritte umfasst.

9. Pastenzusammensetzung nach Anspruch 8, wobei ein Gehalt an der Glasfritte 8 Gew.-% oder weniger beträgt.

10. Pastenzusammensetzung nach Anspruch 8 oder 9, wobei eine durchschnittliche Teilchengröße der Glasfritte im Bereich von 1 bis 4 $\mu$m liegt.

11. Solarzellenelement, das eine Elektrode (8) umfasst, die ausgebildet wird, indem eine Pastenzusammensetzung nach Anspruch 1 auf eine Rückseite eines Silizium-Halbleitersubstrats (1) aufgetragen wird und ein entstehendes Erzeugnis anschließend gebrannt wird.

**Revendications**

1. Composition de pâte utilisée pour former une électrode (8) sur la surface arrière d'un substrat semiconducteur en silicium (1) constituant une cellule solaire au silicium cristallin, la composition de pâte comprenant une poudre d'aluminium en tant que poudre électriquement conductrice,
**caractérisée en ce que**
la teneur totale en fer et en titane contenus dans la composition de pâte en tant qu'éléments d'impuretés inévitables est inférieure ou égale à 0,07 % en masse, et

**EP 2 157 618 B1**

dans laquelle de la poudre d'aluminium dont la teneur totale en fer et en titane est supérieure ou égale à 0,09 % en masse et de la poudre d'aluminium de haute pureté dont la teneur totale en fer et en titane est inférieure ou égale à 0,09 % en masse sont utilisées en combinaison.

**2.** Composition de pâte selon la revendication 1, dans laquelle la teneur en fer est inférieure ou égale à 0,07 % en masse.

**3.** Composition de pâte selon la revendication 1, comprenant en outre un véhicule organique.

**4.** Composition de pâte selon la revendication 3, dans laquelle la teneur en véhicule organique est supérieure ou égale à 18 % en masse et inférieure ou égale à 38 % en masse.

**5.** Composition de pâte selon l'une quelconque des revendications 1 à 4, dans laquelle la teneur en poudre d'aluminium est supérieure ou égale à 58 % en masse et inférieure ou égale à 78 % en masse.

**6.** Composition de pâte selon l'une quelconque des revendications 1 à 5, dans laquelle les dimensions moyennes des particules de la poudre d'aluminium se situent dans la plage allant de 1 μm à 20 μm.

**7.** Composition de pâte selon l'une quelconque des revendications 1 à 6, dans laquelle de la poudre d'aluminium dont la teneur totale en fer et en titane est de 0,005 % en masse et de la poudre d'aluminium de haute pureté dont la teneur totale en fer et en titane est de 0,2 % en masse sont utilisées en combinaison.

**8.** Composition de pâte selon la revendication 1, comprenant en outre une fritte de verre.

**9.** Composition de pâte selon la revendication 8, dans laquelle la teneur en fritte de verre est inférieure ou égale à 8 % en masse.

**10.** Composition de pâte selon la revendication 8 ou 9, dans laquelle la dimension moyenne des particules de fritte de verre se situe dans la plage allant de 1 μm à 4 μm.

**11.** Élément de cellule solaire comprenant une électrode (8) formée en appliquant une composition de pâte selon la revendication 1 sur la surface arrière d'un substrat semiconducteur en silicium (1) et en cuisant ensuite le produit résultant.

FIG.1

FIG.2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000090734 A
- JP 2004134775 A
- JP 5129640 A
- JP 2001202822 A
- CN 1877864 A